# EUROPEAN PATENT APPLICATION

(11) **EP 4 839 028 A1**
(43) Date of publication of application: **11.11.2026**
(21) Application number: 26176035.9
(22) Date of filing: 01.05.2026
(51) Int. Cl.: H05K 1/11

(54) **OFFSET CHAMFER ON WAFER IN A CONNECTOR SYSTEM**

(30) Priority: 06.05.2025 US 202519199501
(71) Applicant: TE Connectivity Solutions GmbH, 8200 Schaffhausen (CH)
(72) Inventor: GINGRICH III, Charles Raymond, MIDDLETOWN, 17057 (US)
(74) Representative: Ashton, Gareth Mark

(57) **Abstract**

A circuit board for inserting into a circuit board receiving slot of a mating electrical connector. The circuit board includes a first side surface and a second side surface which is opposed to the first side surface. A mating end extends between the first side surface and the second side surface. The mating end is configured to be inserted into the circuit board receiving slot the mating electrical connector. An offset chamfered edge is provided on the mating end, The offset chamfered edge has a peak, a first angled surface, and a second angled surface, with the peak being offset from a longitudinal axis of the circuit board.

## Description

The invention relates generally to a substrate or wafer with an offset chamfer on a leading or mating end. In particular, the invention is directed to a substrate or wafer with an offset chamfer which reduces mating forces and which helps prevent stubbing of the substrate or wafer when it is mated with mating connector.

Electrical connectors for interconnecting a circuit board backplane to a daughterboard generally comprise two mating connector halves. One of the mating halves commonly includes a plurality of wafers or circuit boards which include signal carrying traces and ground traces. These connectors have a high contact density and are required to operate at relatively high electrical speeds. Due to continuing trends toward miniaturization and improved electrical performance by the electronics industry, requirements for greater contact density and higher electrical speeds are constantly being promulgated. Consequently, as density increases, the alignment of the connector halves becomes increasingly difficult. In particular, as the wafers are inserted into wafter receiving slots of the mating connector, stubbing of the wafters with the contacts of the mating connector can be significant. In addition, the mating force required to insert multiple wafters into multiple wafer receiving slots can be problematic.

It would therefore be beneficial to provide a connector system in which the mating force and the stubbing between mating connectors is minimized. In particular, it would be beneficial to provided substrates or wafers with mating edges that have offset chamfers which allows for reduced insertion force and reduced stubbing during mating.

The solution is provided by a circuit board for inserting into a circuit board receiving slot of a mating electrical connector. The circuit board includes a first side surface and a second side surface which is opposed to the first side surface. A mating end extends between the first side surface and the second side surface. The mating end is configured to be inserted into the circuit board receiving slot the mating electrical connector. An offset chamfered edge is provided on the mating end, The offset chamfered edge has a peak, a first angled surface, and a second angled surface, with the peak being offset from a longitudinal axis of the circuit board.

The invention will now be described by way of example with reference to the accompanying drawings in which:
FIG. 1 is a perspective view of an illustrative connector assembly of the present invention with the daughter card connector assembly and the backplane connector assembly shown in an unmated state.
FIG. 2 is a cross-sectional view of a portion of the daughter card connector assembly and a portion of the backplane connector assembly prior to mating.

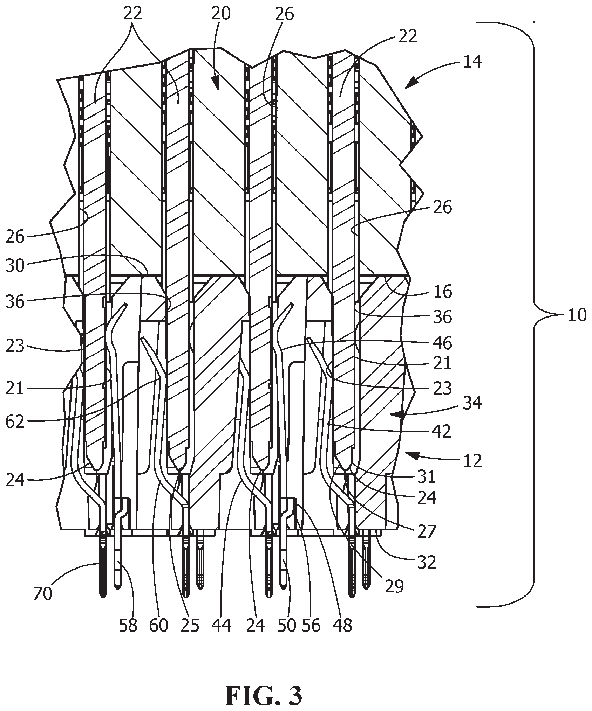

FIG. 3 is a cross-sectional view of the portion of the daughter card connector assembly and the portion of the backplane connector assembly of FIG. 2 shown in the mated position.
FIG. 4 is an enlarged cross-sectional view of the portion of the daughter card connector assembly and the portion of the backplane connector assembly indicated by the broken line 4 in FIG. 2.

An embodiment is directed to a circuit board for inserting into a circuit board receiving slot of a mating electrical connector. The circuit board includes a first side surface and a second side surface which is opposed to the first side surface. A mating end extends between the first side surface and the second side surface. The mating end is configured to be inserted into the circuit board receiving slot the mating electrical connector. An offset chamfered edge is provided on the mating end, The offset chamfered edge has a peak, a first angled surface, and a second angled surface, with the peak being offset from a longitudinal axis of the circuit board. The longitudinal axis may be perpendicular to the mating end, mid-way between the first side surface and the second side surface.

An embodiment is directed to a circuit board for inserting into a circuit board receiving slot of a mating electrical connector. The circuit board includes a mating end and an oppositely facing trailing end. The mating end is configured to be inserted into the circuit board receiving slot in the mating electrical connector. A first side surface extends from the mating end to the trailing end. A second side surface is opposed to the first side surface and extends from the mating end to the trailing end. An offset chamfered edge is provided on the mating end. The offset chamfered edge has a peak, a first angled surface, and a second angled surface. The peak is offset from a longitudinal axis of the circuit board. The first angled surface extends from the peak to the first side surface and is angled back toward the trailing end of the circuit board. The second angled surface extends from the peak to the second side surface and is angled back toward the trailing end of the wafer.

An embodiment is directed to an electrical connector with a housing holding a plurality of wafers. The wafers include mating ends and oppositely facing trailing ends. The mating ends are configured to be inserted into circuit board receiving slots in a mating electrical connector. First side surfaces of the wafers extend from the mating ends to the trailing ends. Second side surfaces are opposed to the first side surfaces. The second side surfaces extend from the mating ends to the trailing ends. Offset chamfered edges are provided on the mating ends. The offset chamfered edges have peaks, first angled surfaces, and second angled surfaces. The peaks are offset from longitudinal axes of the wafers. The offset chamfered edges prevent stubbing of the wafers as the wafers are inserted into the circuit board receiving slots in the mating electrical connector.

Exemplary embodiments of the present invention are now described with reference to the Figures. Reference numerals are used throughout the detailed description to refer to the various elements and structures. Although the following detailed description contains many specifics for the purposes of illustration, a person of ordinary skill in the art will appreciate that many variations and alterations to the following details are within the scope of the invention. Accordingly, the following embodiments of the invention are set forth without any loss of generality to, and without imposing limitations upon, the claimed invention.

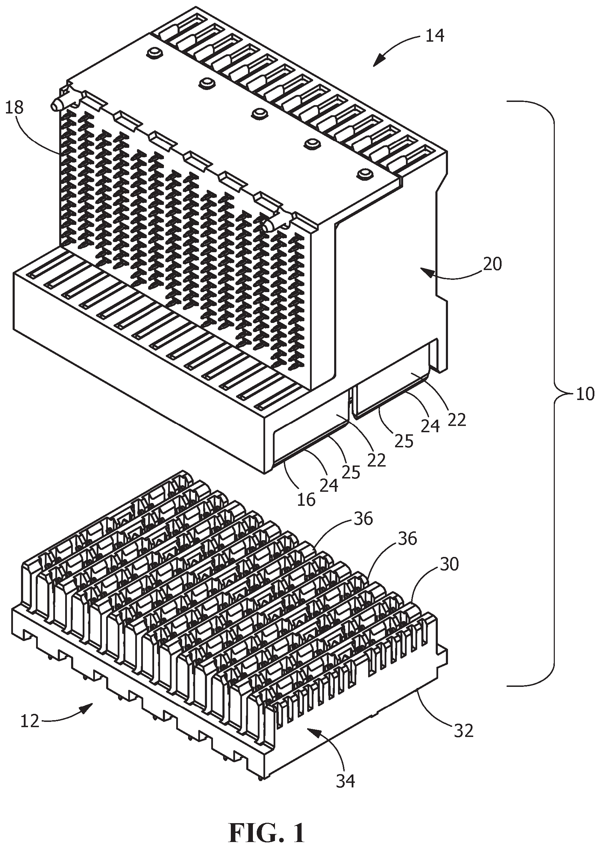

FIG. 1 illustrates an illustrative electrical connector system 10 having a backplane connector 12 and a daughtercard connector 14 that are used to electrically connect a backplane circuit board (not shown) and a daughtercard circuit board (not shown). While the electrical connector system 10 is described herein with reference to backplane connectors 12 and daughtercard connectors 14, it is realized that the subject matter herein may be utilized with different types of electrical connectors other than a backplane connector or a daughtercard connector. The backplane connector 12, and the daughtercard connector 14 are merely illustrative of an electrical connector system 10.

In the illustrative embodiment shown, the daughtercard connector 14 constitutes a right angle connector wherein a mating interface 16 and mounting interface 18 of the daughtercard connector 14 are oriented perpendicular to one another. The daughtercard connector 14 is mounted to the daughtercard circuit board at the mounting interface 18. Other orientations of the interfaces 16, 18 are possible in alternative embodiments.

The daughtercard connector 14 includes a housing 20, made of one or more components, holding a plurality of substrates or wafers 22, such as, but not limited to circuit boards therein. The wafers or circuit boards 22 have mating ends 24. The wafers 22 may have different configurations, such as, but not limited to, microstrip (two layer) or stripline (four or more layers). In the illustrative embodiment, the wafers 22 have signal pathways or traces (not shown) on one side 21 and ground plane members (not shown) on the opposed side 23. The signal pathways or traces and ground plane members extend to proximate mating ends 24 of the wafters 22. The mating ends 24 are positioned in a recess 26 of the housing 20 which extends from the mating interface 18 of the housing 20.

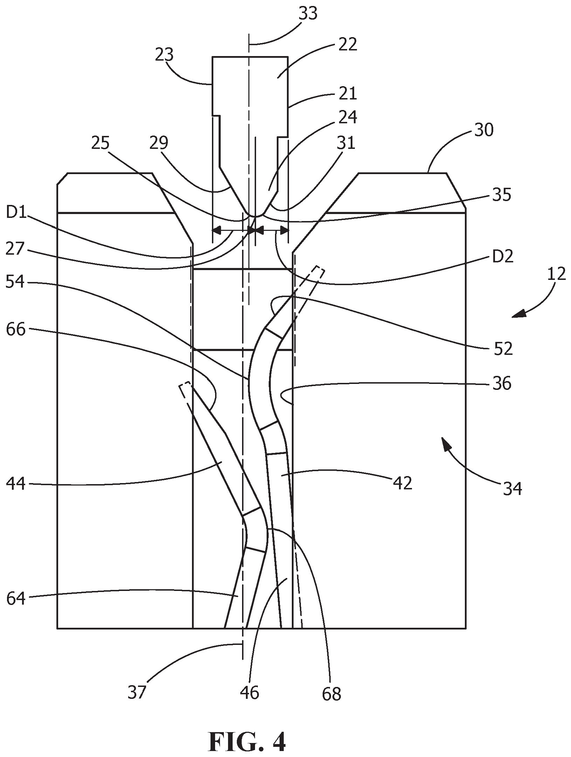

As shown in FIG. 4, the mating ends 24 of each of the wafers 22 has an offset chamfered edge 25. The offset chamfered edge 25 has a peak 27, a first inclined or angled surface 29, and a second inclined or angled surface 31. The peak 27 is offset from a longitudinal axis 33 of the wafer 22, the longitudinal axis being perpendicular to the mating end 24, mid-way between the first side surface 21 and the second side surface 23. The first angled surface 29 extends from the peak and is angled back toward a trailing end of the wafer 22. The second angled surface 31 extends from the peak and is angled back toward the trailing end of the wafer 22. The circuit board has a thickness direction perpendicular to the longitudinal axis 33 and in the illustrative embodiment shown, the distance D1 in the thickness direction that the first angled surface 29 extends from the side 23 of the wafer 22 to the peak 27, is greater than the distance D2 in the thickness direction that the second angled surface 31 extends from the side 21 of the wafer 22 to the peak 27, However, other configurations, including, but not limited to, the first angled surface 29 being smaller than the second angled surface 31, may be used. The angle provided between: the first angled surface 29 and the side 23; the second angled surface 31 and the side 21; and the first angled surface 29 and the second angled surface 31 may vary depending upon the desired configuration. In the illustrative embodiment shown, the peak 27 has a rounded outer surface 35. In the embodiment shown, the width of the mating ends 24 of each of the wafers 22 is smaller than the width of the reminder of the wafer 22. The first angled surface 29 includes a stepped or shouldered portion adjoining the side 23 and the second angled surface 31 includes a stepped or shouldered portion adjoining the side 21.

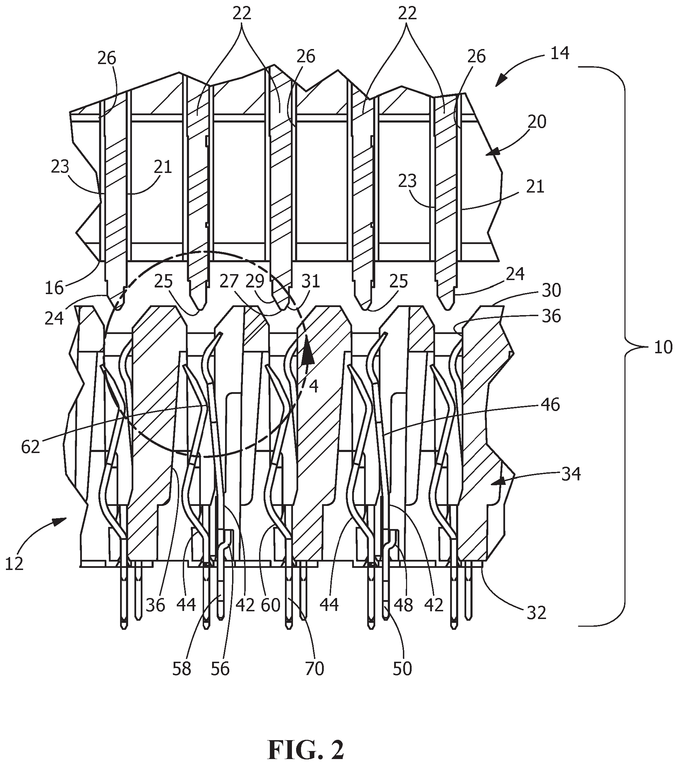

In the illustrated embodiment, the backplane connector 12 constitutes a header connector mounted to the backplane circuit board. However, other types of connectors may be used. When the backplane connector 12 is mated to the daughtercard connector 14, the daughtercard circuit board is oriented generally perpendicular with respect to the backplane circuit board. Referring to FIGS. 1 and 2, the backplane connector 12 includes a mating end 30 and a mounting end 32 that are oriented generally parallel to one another.

In the illustrative embodiment, the backplane connector 12 includes a one piece housing 34. Alternatively, the housing may include a plurality of individual housings or modules. The housing 34 has one or more substrate or wafer receiving slots 36 which extend from the mating end 30 toward the mounting end 32.

The housing 34 holds at least one row of signal contacts 42 and at least one ground shield contact member 44. The at least one row of signal contacts 42 are positioned on one side of the one or more wafer receiving slots 36. The at least one ground shield contact member 44 is positioned on an opposed side of the one or more wafer receiving slots 36.

The signal contacts 42 extend between the mating end 30 and the mounting end 32. In the exemplary embodiment, the signal contacts 42 are arranged in pairs carrying differential signals. However, in other configurations, the signal contacts 42 may not be arranged in pairs for carrying differential signals, such as carrying single ended signals. The ground shield contact member 44 extends between the mating end 30 and the mounting end 32.

Each signal contact 42 has a resilient contact arm 46, a securing section 48 and circuit board mounting section 50. In the illustrative embodiment shown, each of the resilient contact arms 46 has a lead in portion 52 and an engagement portion 54. The resilient contact arms 46 are configured to press against signal conductive pads 24 of the signal traces of wafers 22 of the daughter card connector 14 when the daughter card connector 14 is inserted into the wafer receiving slots 36 of the backplane connector 12.

The securing sections 48 have retention members 56, which may be, but are not limited to barbs or projections, which extend from surfaces of the securing sections 48. The retention members 56 cooperate with the housing 34 to retain the signal contacts 42 in the backplane connector 12.

The circuit board mounting sections 50 have compliant portions 58, such as an eye of the needle pins, although other configurations may be used. The circuit board mounting sections 50 cooperate with the backplane circuit board to retain the signal contacts 42 to the backplane circuit board. The configuration of the signal contacts 42 is meant to be illustrative as other embodiments of the signal contacts may be used.

In the illustrative embodiment, the ground shield contact members 44 have curved working spring portions 60. Ground shield resilient contact beams or ground shield contact spring fingers 62 extend from first ends of the curved working spring portions 60. The ground shield contact spring fingers 62 are configured to press against the ground plane member of the substrates or wafers 22 when the daughter card connector is mated to the backplane connector 12. The particular configuration of each of the ground shield contact beams 62 may vary or may be uniform.

Mounting members 70 extend from second ends of the curved working spring portions 60. In the embodiment shown, the mounting members 70 are eye of the needle compliant members, but other types of mounting members 70 may be used.

As the backplane connector 12 and the daughtercard connector 14 are mated together, the mating ends 24 of the wafers 22 of the housing 20 of the daughtercard connector 14 are moved past the mating end 30 of the housing 34 into the wafer receiving slots 36. As insertion occurs, the longitudinal axes 33 of the wafers 22 are positioned essentially inline with longitudinal axes 37 of the wafer receiving slots 36. As the peaks 27 of the offset chamfered edges 25 are offset from the longitudinal axes 33 of the wafers 22, the peaks 27 of the offset chamfered edges 25 are also offset from the longitudinal axes 37 of the wafer receiving slots 36, as shown in FIG. 4.

As insertion continues, the second angled surfaces 31 of the offset chamfered edges 25 engage the lead in portions 52 of the resilient contact arms 46 of the signal contacts 42. Continued insertions causes the lead in portions 52 to slide along the second angled surfaces 31, causing the resilient contact arms 46 to be moved to a stressed position in which the engagement portions 54 are moved away from the longitudinal axes 37 of the wafer receiving slots 36.

With the resilient contact arms 46 properly maintained in a stressed position, insertion of the wafers 22 into the wafer receiving slots 36 is continued. As this occurs, the first angled surfaces 29 of the offset chamfered edges 25 engage the lead in portions 66 of the resilient contact arms 64 of the ground shield contact members 44. Continued insertions causes the lead in portions 66 to slide along the first angled surfaces 29, causing the resilient contact arms 64 to be moved to a stressed position in which the engagement portions 68 are moved away from the longitudinal axes 37 of the wafer receiving slots 36.

With the daughtercard connector 14 and the backplane connector 12 fully inserted and the wafers 22 properly positioned in the wafer receiving slots 36,. the engagement portions 54 of the signal contacts 42 apply force to the signal traces on the side 21, thereby ensuring that the engagement portions 54 of the signal contacts 42 are positioned and maintained in mechanical and electrical engagement with the signal traces. In addition, the engagement portions 68 of the ground shield contact members 44 apply force to the ground plane members on the side 23, thereby ensuring that the engagement portions 68 of the ground shield contact members 44 are positioned and maintained in mechanical and electrical engagement with the ground plane members.

In the embodiment shown and described, the offset chamfered edges 25 initially make physical contact with the signal contacts 42, as the signal contacts 42 are longer, with the lead in portions 52 positioned closer to the mating end 30 of the backplane connector 12. However, in other embodiments in which the ground shield contact members 44 are longer and the lead in portions 66 are positioned closer to the mating end 30 of the backplane connector 12, the offset chamfered edges 25 would initially make physical contact with the ground shield contact members 44.

The use of the offset chamfered edges 25 and the staggered length of the signal contacts 42 and ground shield contact members 44 allows for reduced mating force as the backplane connector 12 and the daughtercard connector 14 are mated together. In addition, the offset chamfered edges 25 help prevent the stubbing of the wafers 22 on of the signal contacts 42 and ground shield contact members 44. The offset chamfered edges 25 provide more stub resistant lead ins on one side of the wafers 22 (in the illustrative embodiment shown, the first angled surface 29) vs the opposite side (in the illustrative embodiment shown, the second angled surface 31). These offsets are useful in applications where one side 23 of the wafers 22 mates with ground shield contact members 44 and the other side 21 mates with signal contacts 42. Depending upon the configuration of the backplane connector 12, either the ground shield contact members 44 or the signal contacts 42 are often more susceptible to stubbing than the other. The offset chamfered edges 25, with the peaks 27 offset from the longitudinal axes 33 of the wafers 22 allows this problem to be overcome, preventing stubbing during insertion.

## Claims

1. A circuit board (22) for inserting into a circuit board receiving slot (36) of a mating electrical connector (12), the circuit board comprising:
a first side surface (23);
a second side surface (21) opposed to the first side surface;
a mating end (24) extending between the first side surface and the second side surface, the mating end (24) configured to be inserted into the circuit board receiving slot (36) of the mating electrical connector;
an offset chamfered edge (25) provided on the mating end, the offset chamfered edge having a peak (27), a first angled surface (29), and a second angled surface (31), the peak (27) being offset from a longitudinal axis (33) of the circuit board.

2. The circuit board as recited in claim 1, wherein the first angled surface (29) extends from the first side surface (23) to the peak (27).

3. The circuit board as recited in claim 2, wherein the first angled surface (29) extends from the peak (27) and is angled back toward a trailing end of the circuit board, the trailing end being opposed to the mating end (24).

4. The circuit board as recited in claim 1, 2 or 3, wherein the second angled surface (31) extends from the second side surface (21) to the peak (27).

5. The circuit board as recited in any preceding claim, wherein the second angled surface (31) extends from the peak (27) and is angled back toward the trailing end of the circuit board (22).

6. The circuit board as recited in any preceding claim, wherein the length of the first angled surface (29) is longer than the length of the second angled surface (31).

7. The circuit board as recited in any preceding claim, wherein the peak (27) has a rounded outer surface.

8. The circuit board as recited in any preceding claim, wherein the first side surface (23) has signal pathways provided thereon, and the second side surface (21) has ground plane members provided thereon.

9. The circuit board as recited in any preceding claim, wherein the second side surface (21) has signal pathways provided thereon, and the first side surface (23) has ground plane members provided thereon.
